# EUROPEAN PATENT APPLICATION

(11) **EP 2 320 487 A2**
(43) Date of publication of application: **11.05.2011**
(21) Application number: 10466024.6
(22) Date of filing: 15.09.2010
(51) Int. Cl.: H01L 35/30, F21S 9/04

(54) **Thermoelectric lamp**

(30) Priority: 16.09.2009 CZ 20090611
(71) Applicant: Simka, Pavel, 33901 Klatovy (CZ)
(72) Inventor: Simka, Pavel, 33901 Klatovy (CZ)

(57) **Abstract**

Device for the production of light contains at least one thermoelectric element (1), which is in thermal communication with a source of thermal energy (5), the electricity for production of light is generated by thermal effects on the surfaces of element (1) through heat pumping (2), and the transformation of thermal energy into electrical energy is realized and electricity is produced in at least one thermoelectric cell, produced current is led into the controller of charge and/or discharge (14), and/or into at least one accumulator (22), and the regulator of charge and/or discharge is connected through power lines (15) on at least one lighting element (16), which provides conversion of electric energy to light and is connected with at least one switch (17) and leads into the regulator charge and/or discharge, and characteristic is that, the electrical current leads through at least one lighting element (16), the device transmits light energy and the light is on.

## Description

### TECHNICAL FIELD

The technical solution relates to the use of thermal energy of one or more substances or materials for thermoelectric electricity generation using at least one thermoelectric cell or element and its subsequent use for manufacture of light and/or to power other electrical appliances.

Heat energy and temperature differences usable for power generation and especially for production of light presented in this invention occur generally thanks to an energetic action, either is natural or we can say is artificially induced, for example from human activities.

In the case of the natural thermal energy it is mainly on the use of direct sunlight or thermal energy stored from the sun or from the earth's core into air, water, soil and various substances, things and objects which are exposed to effect of such thermal energy.

The induced thermal energy are also generated in system operations of various devices, machinery and equipment, in which is simply generated heat or cold. An example is the heat transfer at different heating or cooling systems, heat pumps, heat engines, combustion engines, electric equipments, machines and equipments, electrical generators, the different thermal circles and thermal cycles, etc..

Because the heat energy always flows from the warmer to the cooler environment, it is possible by inserting at least one thermoelectric element, thermoelectric cell or thermoelectric foil between these environments to generate the electricity. In this way produced electricity can be used directly or can be stored in the batteries for further use.

### BACKGROUND ART

In the current state of the art the electrical energy for lighting is distributed through networks to the points of consumption, especially to households, businesses, government buildings and to various devices and things. The distribution networks are supplied from various sources such as thermal powers, nuclear powers, renewable sources, particularly water, wind and fotovoltaic solar powers. It is also known the production of electricity through turbines located on the surface and the thermal energy is extracted from deep underground wells typically 5-10 km and such energy originates from the Earth's core.

It is clear that such ways of producing electricity are expensive for build and usually also for the subsequent maintenance in their working conditions. The buildings and houses use various sources of heat or cold. These sources are often connected to the electricity distribution network or produces heat in other ways, for example through incineration. A gas, propane, oil, coal, wood, coke, biomass and so on are used. The heat sources are now also increasingly thermal solar systems. Inside the buildings and premises with the occurrence of heat sources is for lighting implemented daylight and/or electric light which powered from the electrical distribution network.

Interior and exterior lighting is now realized mainly with traditional bulbs, mini and micro bulbs, high voltage or low voltage halogen lamps, energy-saving light bulbs, fluorescent lamps, tubular fluorescent lamps, then more recently with lights with luminous LEDs and the like. The field of lighting is fairly rapidly developing. While traditional 100W bulb consumes per 1000 hours 100kWh of electricity, the saving 20W bulb with the same intensity consumes 20kWh, 4W LED lamp only 4kWh. Incandescent light bulb has a high power consumption and short life. Energy saving lamps - fluorescent tubes have high energy efficiency, lower energy consumption, longer life, but the higher weight and must be disposed as hazardous waste. LED luminaire is working with a much lower power consumption, several times longer life and minimal heat output.

Before the electrification were used gas lights and kerosene lamps. Historically the first model of bulb was introduced in 1879, the glow wire was made from the charred cotton fibers.

Principle of the electric light bulb is in incandescent conductive wire, which emits light. After the switch on the switching current flows through the wire or filament, the filament heats up and leads to the creation of so-called Joule's heat. When the current is increasing, the temperature of the filament grows and in a certain interval also the efficiency of light bulb is increasing. With the initial low temperatures, much of the electric energy is transformed into heat and only a part into the light. These reasons have led to the development of the glass bulb filled with inert gas, which also prevents evaporation of the filament. For example, the tungsten wire can be heated up to the temperatures around 2800 °C without having to evaporate. The melting temperature of tungsten is 3400 °C. Gradually, the equal filament moved into a spiral form. The reason was to reduce heat loss, the filament in spiral form is able better to radiate heat and heats up themselves, thereby increasing the bulb efficiency. The most sophisticated light bulbs still have the disadvantage of a relatively small efficiency, because the electrical energy is converted into heat. In some countries, complementing of traditional electric bulbs for sale to ordinary consumers is banned.

In saving lamps and fluorescent tubes are used for creating of electrical discharge relatively low voyages in very dilute gas. In this anode-light the discharge occurs when the voltage per unit length reaches a sufficient value. Glass wall inside the tube is covered with layer of fluorescent substance that itself emits light for illumination. This will increase the efficiency of fluorescent lamps, in which a great deal of radiant energy is in ultraviolet light. Ultraviolet light by the fluorescence changes into the visible light. The cathode-light is used in so-called glow, which are filled with neon under low pressure. The advantage is that they start on very small current. Furthermore, we have arc lamps, which are practically a point source of light. Between tungsten electrodes is created an electric arc in mercury or sodium vapors. The lamp transmits light, which is used to illuminate public spaces and the like. The disadvantage of anode and cathode lamps and arc lamps is greater weight and the fact that they must be disposed as hazardous waste.

It is obvious that the light is a very important factor in how satisfied are people in housing, employment and other activities. It is reported that the annual energy consumption for lighting in the common household is around 1.8 GJ. Large amount of energy is also consumed for street lighting and in residential agglomerations.

In order to save natural resources and less environmental pollution from the fumes of traditional energy sources is important for the future greater use of renewable sources for heating and cooling and also for alternative electricity production of electricity. What is important is also the development of electrical appliances and of lights. Electric appliances with low power and lights, lamps and lighting with new construction will make better use of independently produced electricity in every household, in the field of human activity or around the country and nature. This will reduce burden of power plants and networks.

On the Earth falls from the Sun the solar radiation. Solar thermal energy is accumulated in various materials, goods and articles. Above the Earth's surface is thermal energy contained in the air and atmosphere. The flow of energy from the Sun to Earth is about 1.4 kW.m². Only a small proportion of thermal energy flows towards the surface of the Earth's from the core. Solar radiation drives almost all the processes that take place on the Earth. On the solar energy is dependent climate, temperature, weather changes, contributes to the inflow and outflow. The Sun helps keep the surface water in liquid form and the light is essential for photosynthesis of plants and allows to animals see.

Accumulated heat energy or from the Sun falling heat energy or energy created as a secondary or residual waste from households, from various industrial processes and thermal cycles can be effectively captured and used, directly or through its accumulation for heating or cooling, but also for production of electricity, for example through thermoelectric cells. Such a system of collection and transfer of thermal energy into thermoelectric generator is proposed in the patent application Simka - WO2008/014726. This application describes an alternative electricity generation using thermoelectric phenomena, which are created from thermal energy action on the thermoelectric cell, elements or foils. With the advantage can be used of working circuits of heat pumps, refrigeration and air conditioning equipments, various heating systems, cooling systems, thermal circles, thermal cycles, the accumulated or direct solar radiation, in particular renewable energy sources and the like. So produced electricity can be also used for lighting, as is shown in the examples of the use of the application.

This invention also addresses just a lamp or a light, which is primarily powered by electricity generated in the thermoelectric layers when heating or cooling is realized. Lighting circuit can be connected also to another power source, such as to electricity from the distribution network or from photovoltaic cells, from wind or hydro power plants and the like. The thermal energy transformed into electricity by way of thermoelectric layers and next converted into light, originating from at least one heat pump cycle, and preferably from renewable natural source, mean a new way of lighting, new constructions and designs of lamps.

### DISCLOSURE OF THE INVENTION

Weaknesses mentioned in particular by the existing light sources such as incandescent bulbs and energy saving light bulbs, fluorescent and their remote electricity supply necessary for the operation largely eliminates the "heat lamp" and "light source" according to this invention. Such light sources can be designed to be portable or stationary or built-in. Built-in arrangement presupposes in particular, permanent connection of thermoelectric generator with a heat source, such as condensers of different types of heat pumps, refrigerators or other sources of heat energy.

The invention uses thermal energy of one or more substances or materials by way of heat pumping, which provides potential of heat energy to usable for electricity production through at least one thermoelectric cell, layer or foil for subsequent use of electricity so obtained, particularly for the production of light in lamps and lights or for the other electrical applications.

For creating of the thermal effect on at least one thermoelectric cell, layer or foil can be used with advantage of closed or opened temperature cycles. The transfer of heat energy, heat or cold from the selected source can also be realized using the effect of evaporation or condensation heat of suitable fluid. Such substances can be particularly different refrigerants, so-called natural refrigerants such as CO₂, water, mixtures of water and various additives, gases, air, their different mixtures and the like.

While passing the current through wire occurs the conversion of electric energy into heat. The more current passing through the wire, the more heat is produced. Too much heat can lead to state, when the wire gives the light. This principle is used in incandescent bulbs and in arc lamps.

If we combine the two wires from different metals and one of them we will heat, the so-called thermoelectric voltage is developed between connections. This phenomenon is called the thermoelectric effect. When the thermoelectric cells are at different temperatures on both sides the electricity is generated. Thermoelectric cells can be associated. The most important are mainly so-called Seebeck and Peltier effects, which are reciprocal.

It is clear that on both sides of the thermoelectric cell with different temperatures, can be one heat transfer fluid or substance. Also two different heat transfer fluids or substances can be each on one side of thermoelectric cell. Further, two or more media or materials can be on the one side and on the other side of thermoelectric cell. Also different effects can occur in a larger number of thermoelectric cells or foils. These can be located in an area next to each other or can be stacked on each other, and they can overlap or can be mutually displaced. The most important is the quality of the connections of pillars inside cells and thermal transitions between the outer surfaces of cells. The heat spreading within the meaning of the second law of thermodynamics. In most cases in practice, the heat spread in the area thanks to the temperature difference in all ways simultaneously. It is conduction, convection or radiation. One way of sharing of heat a majority prevails.

A simple thermoelectric generator is obtained by placing thermoelectric cell between two walls that are made from heat-conductive material which is adapted into heat exchanger wall. For example from copper or aluminium. Among the metal wall is placed at least one thermoelectric cell. The walls are placed into two bowls. One bowl is filled with warm water and the second with cold water and ice in order to obtain a sufficient temperature difference between the two substances. Very simply, the higher temperature gradient is in the article, when the more heat will flow through the thermoelectric layer, and also the greater the electrical current is produced, which can also be routed through regulator to charge the battery or to a wall socket or the terminals or to a suitable appliance. Such an appliance can also be lighting appliances such as energy saving light bulb, lamp, led lamp, sheet-light and the like.

The document WO2008/014726 describes in detail the possibility of using thermal energy of evaporators or condensers or of other sources of heat or cold for thermoelectric power generation, which can be supplemented by electricity produced in photovoltaic layers and/or in the wind or water generators and the like. The document gives a detailed interpretation of the conversion of thermal energy into electricity via thermoelectric transformation, so here are relations without details.

It is obvious that with the electricity from the combined electric generator in this document can be powered the whole range of lighting in homes, workplaces, restaurants, in places of active or passive rest or wherever there is such source within easy reach. Lighting is emphasized because the light is important for all people and animals, so they can see. It is traced that the consumption of electricity for lighting is in a normal household 2.5 to 3% of the total consumption. This amount of electricity can be generated in thermoelectric generators on heating and/or cooling systems. Important for the environment is to use systems of the extent of renewable energy.

Portable or stationary electrical equipment for the production of light, which is based on the power from thermoelectric layers are heat lamps or heat lights according to the present invention. Their design can be adapted to the traditional appearance of energy saving lamps, lamps, fluorescent lighting fixtures, lighting elements and the like. The present invention also has modular power generator which is further extended to other renewable sources of electricity with a basic list of devices, which can be powered by the electricity generated in this way.

The device of the present invention enables the safe production of light or a light energy for lighting. The principle of compact lighting device is based on the conversion of thermal energy gained from a suitable source of heat and/or cold, its conversion into electrical energy in at least one built-in thermoelectric cell and subsequent transformation thus obtained electrical energy to light energy. Characteristic here is that all energy transformation can happen in one compact device, or a lamp and/or in a device with a separate layer(s) or with a lighting element(s). In the case the construction of separate heat lamp is realized, than at least one lighting element is connected to the thermoelectric layer and/or to the electrical parts of device. For the creating of the light effect here is used flow of electric current especially of a low voltage and/or his electrical effects through lighting or visual elements, luminous diodes, elements of LED, LCD, OLED technology, lighting foils, OLED foils, liquid crystals, electroluminescent lighting sheets, lighting cables, various mini and micro lamps, lamps, fluorescent lights, etc.. For example, new OLED technology could help to create a lighting foils, which will be able to apply to, in, on devices of various shapes.

For the good function of heat lamp is advantageous to connect in device a charge controller and an accumulator. The controller can serve as a central switching between the thermoelectric generator and battery power. The controller charging/discharging ensures the correct battery charge and can have integrated also other functions and devices. The accumulator keeps on its clamps voltage, after the power switch located on the lamp or on the heat light is in possition on, it causes the flow of electrical current. Turn on the switch will connect the poles, there will be closed circuit and begin movement of electrons and an electric current through lighting elements and the lighting elements radiate light shine. The connection is made in the way that each lighting element such as a diode for example has voltage for which is intended. The connection of lighting elements in at least one circuit can be in series or in parallel.

When is used an accumulator with more cells then can be interconnected with each other in series or in parallel. When the interconnection is in series the resulting battery voltage is the sum of individual voltage. In parallel interconnection of cells the resulting voltage is the same as for the individual cells, but higher current can be delivered. Individual cells of accumulator must have in parallel interconnection the same voltage and the same internal resistance.

The movement of electric charge within an accumulator is maintained to the detriment of thermal energy which has the effect onto at least one thermoelectric cell. On the detriment of heat energy is on the clamps of the accumulator supplied the electric charge, and the electrical current flows through the closed electrical circuit. When ceases to operate in closed circuit the source of heat energy or otherwise heat pumping, will expire the heat flow on thermoelectric cell(s) and the light will shine from the power source until the accumulator is not discharged. The state of discharge can be controlled by controller of electric charge/discharge. Such manner of devices can be used for bridging the time for which for some reason the source of heat energy is removed. For example, a heat pump or other source of heat energy is removed after the space is heated on the desired temperature. For some a period of time will still operate thermal inertia of the heating system and its parts. The device is also possible to build with a thermal fuse or with the equipment for controlling and regulating of temperature.

Into the device of the present invention is possible also to build a suitable storage of thermal energy. Such heat energy storage is usable to ensure the operation of thermoelectric generator in a shorter period, when the heat source has been disconnected. The heat energy is then pumped from the heat energy accumulator for example by the way of heat pumping using refrigerant or other suitable fluid through the use of phenomena such as evaporation and condensation, which occur by the collecting and delivering of heat energies. The heat pumping can be also solved on the principles of heat pipes and thermosiphons. Custom accumulator of heat energy is made up of a substance that has good thermal conductivity and good thermal absorption and consequently also a good release of stored heat energy.

It is natural that to increase the versatility of the present invention device can be a heat lamp or heat light equipped with clamps or socket for connecting the wires to the power supply from another power source. This can be used if it have not any heat source at the moment. It is obvious that such a device can be constructed mainly as a portable. Alternate source of electricity can be a household electrical socket, which is connected to an electricity distribution network. In this construction will the heat lamp equipped with a constant source of power for a given number of LEDs and/or of lighting elements. Power supply with low current consumption and with voltage in the desired range is obtained by fitting the various resistors on board. Such a power supply can be directly integrated into the controller of charging/discharging.

Another source of electricity that can be connected by wires to the clamps of the heat lamp or of heat light is a wind generator and/or a solar generator and/or a hydro generator and/or another generator of electricity. The electricity can be delivered from the backup accumulator, to which such generator(s) are connected. Such alternative sources can have various constructions, designs and layouts. They can operate as separate modules and also they can complementary each other.

For added convenience, control of the heat lamps of the present invention can be such device equipped on its surface with touch, mini or micro switch-off and/or can be integrated a receiver or a transmitter for receiving of signals from the remote control. In such constructions can be heat lamp switched off on a distance. The control of heat light functions can be integrated into a universal home remote control, which also serves to control a TV and/or other home devices. The remote control can control also other functions such as dimming of lights, switching power supply from another energy source and so on. If desired, you can heat lamps and heat light circuits control with a signal from a mobile phone, PC or via the Internet.

From the perspective of the future are also important light foils which have minimal power consumption and good intensity. They will be well integrated into and/or onto different surfaces of various things.

The versatility of the use of heat lamps and systems operating on this principle is clear and very wide, because in urban areas, in buildings and houses are commonly used sources of heating and/or of cooling or of air conditioning. These sources of heat and/or cold have not been used till now to generate electricity and next to generate lighting. Other wals, how to use this new lighting is for example in a beverage vending machines, lighting of refrigeration cabinets and boxes for beverages and foods. A broad can be use thermal energies of condensators and evaporators of cooling and air conditioning systems for the production of thermoelectricity for subsequent use for lighting and/or for other electrical applications.

### BRIEF DESCRIPTION OF THE DRAWINGS

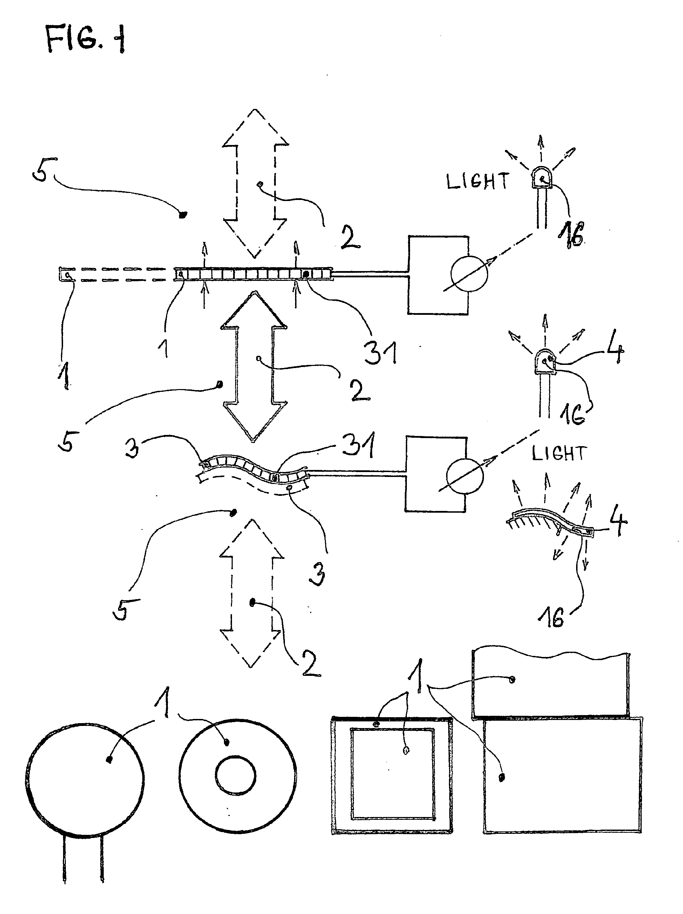

The invention will be further illuminated by drawings on which Figure 1 shows the principle of electricity production through at least one thermoelectric cell, layer, foil, and the electricity is generated in the thermoelectric layer through which heat energy passes, otherwise heat energy is pumped from an environment around of thermoelectric layer and the electricity produced is used mainly for production of light in various types of light emitters and lighting elements, and/or foils. The figure 1 shows the different shapes of thermoelectric cells and/or layers, the possibility of their layering and folding of surfaces together.

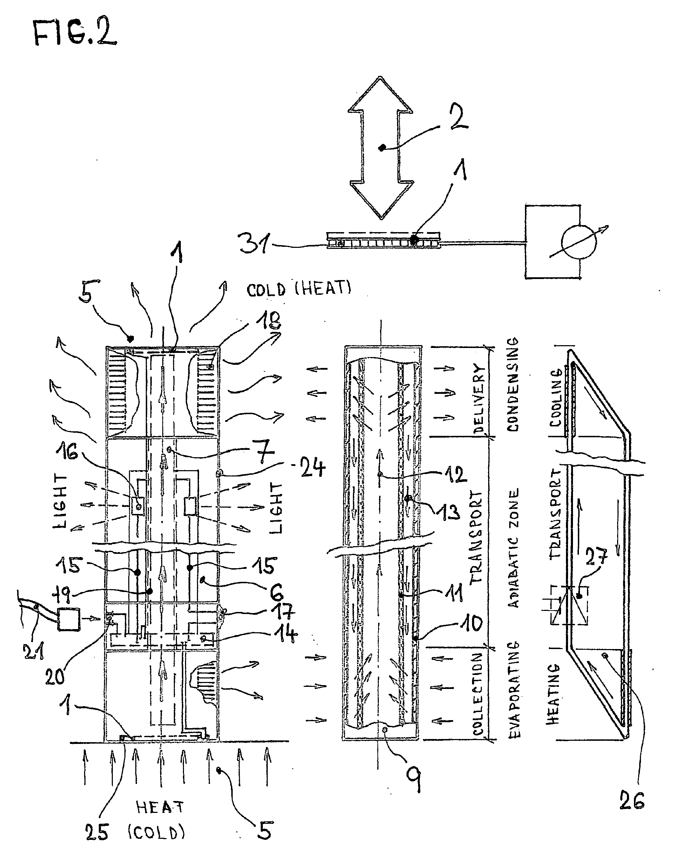

Figure 2 illuminates portable or stationary heat lamp of the present invention, where the thermal energy after passing through at least one thermoelectric element is taken away from his surrounding, from heat conductive material through suitable thermal conductor and/or heat pipe with the function of thermosiphon to the other end of heat lamp, where it can be transferred on next thermoelectric cell(s), and/or can be transferred to the surroundings, for example can be radiated into the air. The figure shows that the cooler can be particularly at one end of the lamp and/or on both ends. There are possible various constructions and locations of the cooler on the lamp and light.

In the second part of the Figure 2 there is used for removing of heat energy a closed circulation circuit. Such a circulation circuit can work as passive, when the circulation of a fluid within the circuit is guaranteed by the gravitational effects, or can be solved as an active with forced circulation, where the heat energy is transfered by liquid and/or by fluid and is powered by mini-pump which is powered from a storage battery.

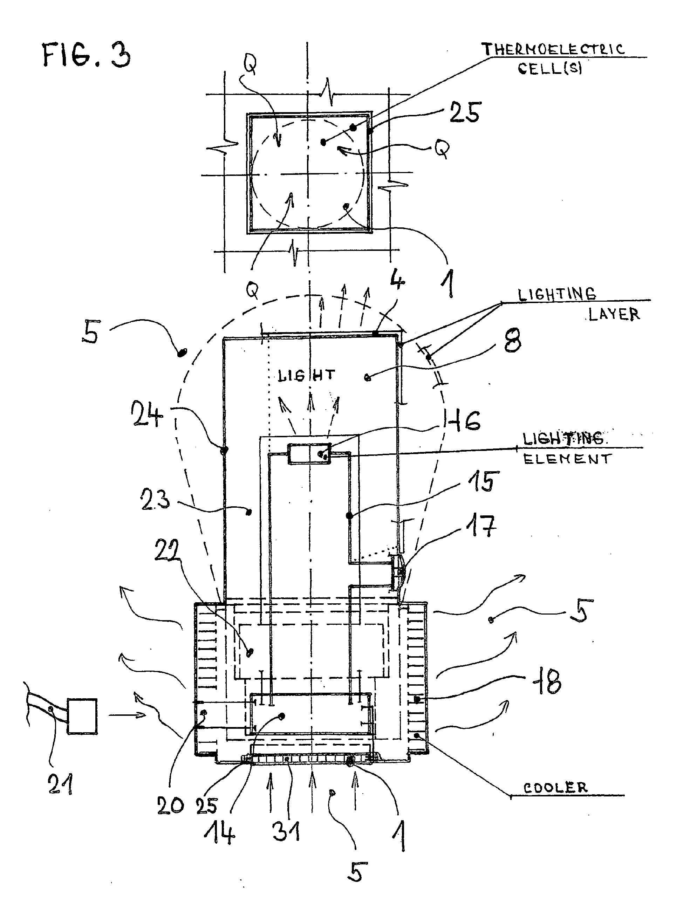

Figure 3 explains the simple construction according to the present invention in particular of portable heat light or heat lamp with the cooler, which is in thermal contact with the upper layer of at least one thermoelectric element, and the cooler provides heat energy dissipation. Heat lamps in Figures no. 2 and 3 can be equipped with a socket for connection via wires and adapter to a different type of power source, for example to a normal electrical outlet and to distribution network. This will be used if the source of heat energy is not available and the batteries are low. Lamps can be equipped with a switch for disconnecting the lamp from the source. Figure 2 shows the cover of the lamp or light which can have various shape with the placement of lighting elements under the cover and/or lighting elements and/or foils can be placed on the surface of the cover.

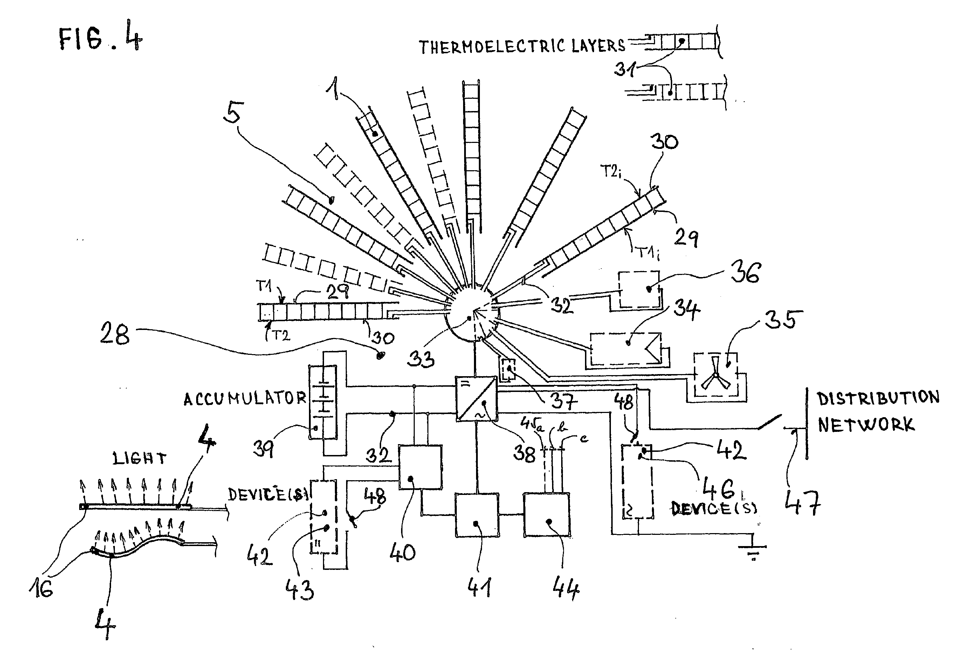

Figure 4 highlights an alternative system for production of electricity or a module generator with highlighting of power supply for the circuit of lights and/or other electric appliances. In one energetic system are associated source of heat and/or cold, and/or thermoelectric generator, and/or photovoltaic generator, and/or wind generator, and/or hydro electric generator, and the generator is at least one, if this one is involved in the system. Next ecological electricity sources, which is possible to connect are co-generation units, sources with fuel cells, systems of hydrogen energy and a like. The system or the total generator allows connection of various electrical devices to direct or alternating electrical current. The system is connected to the distribution electricity network through one-way or two-way communication, and can be operated as disconnected from the network and is equipped with a backup accumulators.

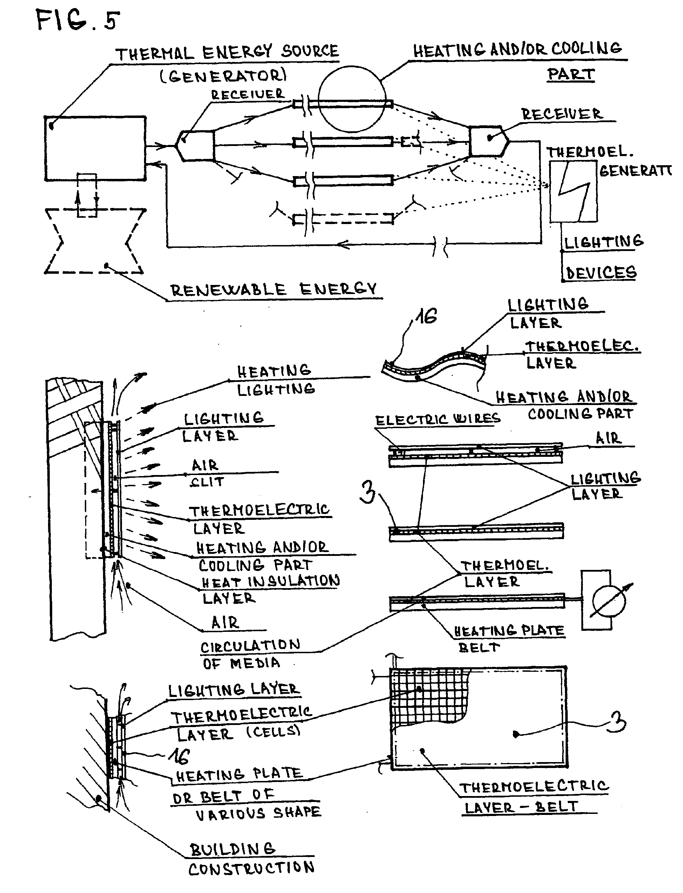

Figure 5 highlights a new type of heat lamps or heat lighting of the present invention, which can be in various shapes with integrated lighting layers on the surfaces, and lighting layers can be also placed with an air gap for air circulation between the thermoelectric layer which is placed on a heating body, plate or belt. Thermoelectric layer can be also placed on the building structure before a heating plate or behind heating plate, and is cooled by air or can be cooled by other heat transfer medium. In this case the heat transfer medium would flow on the other side of the thermoelectric layer. Heating plates and/or belts, thermoelectric layers and/or belts, lighting layers and/or foils can be of various shapes and profiles. In the drawing is a source of heat and/or cold, for example a heat pump, which collects renewable heat energy, and in thermoelectric generator is produced electricity for lighting and/or for other appropriate devices.

### DETAILED DESCRIPTION OF THE PREFERRED EMBODIMENTS

### Example 1

Device 6, as shown in Figure 2 consists of at least one thermoelectric element 1, which is located on the device, here at the bottom part and/or on the top of device and at least one thermoelectric element is in contact with heated or with cooled surface as a source of heat and/or cold 5. Characteristic for this construction is that part of such device 6 is with at least one thermal conductor 7, which provides efficient heat dissipation from the surface of thermoelectric element 1, and from the side which is not in direct contact with the heat source 5, and the side is in optimal construction isolated from its effects. At least one thermoelectric element 1 is placed in such a way, that the area which is in heat contact with the heat source is not in contact with the other side of the element, which is in heat exchange contact with a conductor and/or cooler for heat dissipation. Thermal partition 25 can be made from heat insulating material and/or is solved as a slit. An appropriate construction of heat conductor(s) 7 is for example a metal or a metal alloy, in another embodiment it can be a fluid which evaporates and condenses directly in the body 6 under the cover 24.

Another particularly advantageous construction is when the thermal conductor is constructed as a heat pipe 9, which operates on the principle of thermosiphon. Inside the outer casing of tube 10 is inserted a mesh 11, thanks to which is partially divided the inside volume of the tube 9. Inside the tube is a suitable heat transfer filling, such as for example small amount of distilled water or a refrigerant, which in the bottom part evaporates when receiving the heat and flows up the tube 12, while the heat permeates through the mesh within the heat transfer, and condenses due to difference of temperatures of the surroundings, respectively due to the effect of cold which is coming from the top of the wall of the tube 9. The condensed fluid falls down 13 back into the evaporation part of the thermosiphon. In this way is the effective heat dissipation from the second side of the thermoelectric element 1. The surface of the heat conductor 7 can be insulated with a heat insulation 19 in the section between cooler 18 and bottom part of the device. The lower part of the device 6 can be alternatively also equipped with a cooler. Central part of the device 6 is closed with surface 24, which is characterized in very good light transmission and/or makes the light rays even stronger. Arrow 2 in Figure 1 and 2 shows heat pumping by heat treatment on the surfaces of the thermoelectric cell(s) 1. If a thermal energy permeates the thermoelectric layer, then electricity is produced in such layer. When the heat dissipation from the second side of the element 1 is more effective, respectively, when the higher temperature difference is achieved on both sides of the element 1, then more electricity is produced. The electricity is conducted by conductors from thermoelectric element 1 to the controller of charging/discharging 14, from which is connected also an accumulator. An accumulator as a power source is not drawn here. From the controller 14 continues electrical circuit with wiring 15, which appropriately connect at least one lighting element 16. Lighting elements can have various versions and constructions, for example as low-voltage diodes, lighting foils, fluorescent tubes, mini lamps, OLED foils, LED elements, liquid crystals, etc.. Inside the circuit is connected a circuit switch 17. If the circuit is connected through the switch 17, then current flows from batteries and flows through lighting elements which shining. The heat is conducted to the top of the device 6, where the cooler 18 is located. From the cooler is heat transferred by radiation to surrounding of the cooler, for example to air. Cooler 18 can be alternatively designed as combined, when the heat supplied by thermal conductor 7 or by heat pipe 9 heats further at least one thermoelectric element 1, respectively his one side. The other side of the element is in thermal communication with the material of cooler 18, which for example is so combined and dissipates heat to the surroundings. It is obvious that such coolers can be equipped with a motorized propeller to provide airflow and efficient heat dissipation from the device. Another possibility is a fluid which can carry the heat from the device. Such heat transmission is more efficient than the heat radiation or convection.

If the elements 1 are heated, and the heat energy is sufficiently removed, then the device is generating the electricity. When the switch 17 connects the electric circuit the light for lighting is produced. In the case that heat source is not active and the switch is connected, then the electricity for lighting is supplied from the batteries. The electricity will be supplied from the battery till battery time. The degree of discharge of the battery can be controlled by the regulator discharge/charge 14, in which can be integrated also other parts of the electrical device.

The device according to the present invention can be equipped with a plug or with contacts 20, which serves to connect the cable or wire 21 for power supply to the device from another source of electricity. This connection will be used, especially if the heat source is not available, and/or if this source is insufficient. The source of electricity can be in such case, for example, a standard electrical plug with the electricity from distribution network or with electricity produced by another alternative source such as a wind generator of electricity, a water generator of electricity, chemical generator of electricity, etc.. The cable 21 or wires can be equipped with an electric adapter, which is not drawn here. The device can thus be operated in order to charge the batteries or even on permanent basis. It is obvious that as the heat energy sources can be heat pumps, various domestic and industrial refrigeration and airconditioning equipments, various traditional sources of heating, boilers on biomass, pellets, various heating systems and heaters, solar systems and other renewable sources and devices, goods, substances and materials containing or producing heat and/or cold, or simply heat energies with an appropriate amount and good intensity.

In the second part of the Figure 2, in the device 6 is heat from the surface of at least one thermoelectric element 1 removed through a built-in pipe circulation circuit 26, in which the fluid inside the circuit circulates passively, ie. without the use of power, or the circulation of heat transfer fluid ensures the active drive 27, for example mini or micro pump, which is powered with electricity from the batteries. It is obvious, that in the device 6 according to this invention can be the circuit 26 lead outside of the device for an active cooling. The circulation can be secured with an active drive or can be passive with natural circulation of circulating medium.

### Example 2

The device 8, as shown in Figure 3 consists of at least one thermoelectric element 1, which is located on the device 8, here at the bottom part, which is in contact with heated and/or with cooled surface of source of heat 5 and/or source of cold 5. Characteristic for this construction is that part of such device 8 is without thermal conductor 7, as in the device 6 in Figure 2. Heat dissipation from the other side of the thermoelectric element 1 is realized by conduction to material of the cooler 18, from which is heat transferred mainly by radiation to the surroundings. An active heat dissipation can be realized also by using a minimotor and a propeller. The insulated location of thermoelectric element 1 is solved again with slot 25 and/or with a heat-insulating material. The device is equipped with at least one thermoelectric element 1, which is connected to the controller charge/discharge 14, that is electrically connected to the battery(ies) 22. Furthermore, the regulator of charge/discharge 14 is connected with wires 15 to at least one ligting element 16 and to circuit switch 17, from which the circuit closes on the regulator 14. From the controller 14 is connected the socket 20 or the clamps for connecting of cable 21 for electricity supply from battery and/or for lighting element 16 and other electrical components, with electricity from another source. The equipment with such or similar construction can be placed in another arbitrary position or on the ceiling through suitable fixation, for example through a thread, magnet, hanging etc.. Device 8, heat light or heat lamp is equipped with a cover 24, which transmits light produced by the lamp, or even the light increases. The cover 24 can have various shapes.

### Example 3

The device 8, as shown in Figure 3, in another embodiment can be implemented as a device with thermosiphon, which is directly formed at least partially with a transparent tube 24 and partially with heat conductive case. Implementation of the tube 24 is sufficiently long in relation to its diameter and to function of thermosiphon. Inside the compartment 23 is directly circulated a heat transfer medium through evaporation and condensation, medium for example such as refrigerant. Before filling the compartment inside, the device is evacuated. Heat dissipation works similarly to the internal model with thermosiphon in Figure 2. At the bottom part of device is the evaporation of fluid and in the top part of device is condensation of fluid.

### Example 4

The device 28, shown in Figure 4 consists from module of thermoelectric electricity production, which consists mainly from individual thermoelectric elements 1 or layers 7, 8, with heat exchange surfaces 29 and 30 for removing or for the supplying of thermal energy from heat pumping 2. Individual surfaces of elements have different temperatures T1 and T2, or the thermal energy can be dissipated from thermoelectric elements by heat pumping through thermosiphon, circulation of refrigerants, heat transfer of different materials which are in contact is realized through heat conduction, and/or convection, and/or radiation. Individual thermoelectric elements include thermoelectric layers 31 and all are connected with wiring 32 to a merge 33 of the system. The merge of the system and polarity guard can be connected to at least one photovoltaic generator 34, and/or to at least one wind power generator 35, and/or to at least one water generator of electricity 36, and/or to at least one co-generation generator of electricity, and/or to at least one generator with fuel cells, and/or to at least generator using hydrogen, and/or other ecologic generator of electricity 37. Merge 33 of the system is connected to a voltage regulator 38, then the system consists mainly from the accumulators 39, protection against deep discharge 40, monitor of functioning 41 of the system, the circuit of lighting, lamps and lighting elements 42, and/or other electrical appliances on the direct current 43 with switches 48, temperature measuring 44 with sensors 45 a, b, c, ..., and with the ability to connect appliances using alternating current 46 with switch 48, and with a connection to the electricity distribution network 47. Method of operating such a system for generating of electricity is described in Industrial Applicability. Compared to the document WO2008/014726, where the system is also described, this document describes also possibility of extension of specific electrical appliances on direct and/or on alternating current, such as especially televisions, television signal receivers, radios, audio and video players, lamps and lighting, microwave ovens, computers, printers, mobile phones, telephones, shredders, fax machines, telephones, mixers, food processors, electric kettles, electric cookers and electric ovens, induction hobs, batteries, battery chargers, various toasters, grills, fans, irons, vacuum cleaners, electric hand tools or stationary tools and machines, driving for tools, dishwashers, washing machines, dryers, fans, sewing and knitting machines, mowers, pressure washing equipment, welding machines, refrigerators , freezers, copiers, portable and stationary air conditioning and heaters, heaters and coolers, instruments, meters, compressors, electric motors, water and fluid pumps, various electric heating pads and cables, equipment for temperature and air quality, and/or other appliances, simply various home, office and industrial electric appliances.

### INDUSTRIAL APPLICABILITY

The versatility of using of heat lamps and heat lighting which are operating on the principle of electricity produced by integrated thermoelectric elements is clear and very broad. The device according to the invention can be used wherever heating, cooling, air conditioning, various types of heating and/or cooling is used. For example, in urban areas, in buildings and homes typically are used different sources of heating, cooling and air conditioning. Exploitation is also becoming more and more solar heating. Such sources of heat and/or cold have not been used till now to generate electricity and light for lighting.

Other specific ways of using such devices is lighting of automats for drinks, refrigeration cabinets and boxes for beverages and foods. In general, heat energies of evaporators and condensers of cooling, heating and air conditioning systems can be widely used for the production of electricity for subsequent use for lighting and/or for other electrical applications. For that purpose, however, different heat sources and heating systems can be used. It is clear that usable heat sources for thermoelectric generation of electricity in the thermoelectric layers can be various boilers on fuels, such as solid fuels, liquid fuels, gaseous fuels, heat from the incineration in various boilers, central heating systems and so on. As a source of thermal energy are optimal heat pumps because these are so-called renewable sources of thermal energy. Other environmental heat sources are an ecological boilers, burning of biomass, pellets, solar systems, utilizing of geothermal energy, co-generation units, fuel cells, hydrogen systems, etc..

In this invention described energy system with thermoelectric generator of electricity can be supplemented by a photovoltaic electricity generation module, and/or wind generators, and/or hydro electric generators, and/or by other generators of electricity such as fuel cells, hydrogen systems, cogeneration units and the like. The system includes an accumulators and can be connected through one-way or two-way communication with a local electricity distribution network which can support the whole energy system. In the event of a shortage of electricity which is normally produced by described alternative generator(s), the electricity can be automatically replenished from the electricity distribution network. Another method of operating such energy system is that the generated electricity is sold into the distribution network and appliances are partially or fully powered by electricity from the network. Such a method of operation is dependent upon the purchase price of electricity.

The good power of the alternative electricity from such energy system and/or in combination with the local electricity distribution networks can power various lamps and lighting and other electrical appliances, which are commonly used in the homes or workplaces, home, office, and industrial electric appliances.

### LIST OF CORRELATED SYMBOLS

1 - thermoelectric element
2 - heat pumping
3 - thermoelectric cells, foils, belts
4 - lighting elements, light emitting diodes, LED, OLED, LCD, lighting foils, lighting cables, mini lamps, lamps, fluorescent tubes, liquid crystals, ...
5 - source of thermal energy
6 - device for production of light, heat lamp
7 - thermal conductor
8 - device for the production of light, heat lamp
9 - heat pipe, thermosiphon
10 - wall of the tube
11 - inside of the tube, mesh
12 - direction of flow of fluid
13 - direction of flow of fluid
14 - controller of charge/discharge, and/or other integrated elec. devices
15 - electric lines, wires, optical cables
16 - at least one lighting element
17 - switch
18 - cooler
19 - heat insulation of thermosiphon or of heat conductor
20 - clamps or socket for cable connection
21 - cable and/or wires for connection of emergency source
22 - accumulator
23 - interior part of light, alternatively thermosiphon
24 - cover of lamp, bulb, light
25 - thermal insulation and/or slot
26 - circulation circuit for circulating of heat transfer media
27 - active drive for circulation of media, for example mini pump
28 - generator of elektricity, energy generator
29 - heat exchange surface of thermoelectric element, belt, layer, foil
30 - heat exchange surface of thermoelectric element, belt, layer, foil
31 - thermoelectric layer
32 - conductors, wires, optical cables
33 - merge, device for control of polarity
34 - photovoltaic generator of electricity
35 - wind generator of electricity
36 - water generator of electricity
37 - cogeneration generator, fuel cells, hydrogen system, other ecological generator
38 - voltage regulator
39 - at least one accumulator
40 - protection against deep discharge
41 - monitoring of system functioning
42 - circle of lighting, and/or at least one lamp, and/or lighting element
43 - device(s) on direct current
44 - mesuring of temperature
45 - a, b, c, ... sensors for measuring of temperature
46 - device(s) on alternating current
47 - electrical distribution network
48 - switch and/or switches of lights and/or of devices

## Claims

1. A device for the production of light is **characterized in that**, the device containing at least one thermoelectric element, and/or belt, and/or foil, with at least one thermoelectric layer (31), otherwise at least one thermoelectric element (1), which is in thermal communication with at least one source of thermal energy (5), and electricity for the production of light is generated through thermal action on the surfaces (29, 30) of at least one element (1) in at least one thermoelectric layer (31) by heat pumping (2), where the transformation of thermal energy from energy source into electrical energy is realized.

2. A device according to claim 1 is **characterized in that**, the electrical current produced in at least one thermoelectric element (1), layer, and/or belt, and/or foil of device is led into the regulator charge and/or discharge (14, 40), and/or to at least one accumulator (22, 39), whereas the regulator of charge and/or discharge (14, 40) is connected through electric lines (15, 32) with at least one lighting element (16, 42), which provides conversion of electrical energy to light and is connected with at least one switch (17, 48) and the current leads onto board of regulator charge and/or discharge (14, 40), and/or into a voltage regulator and current regulator (38), and/or is involved in electrical circuit of a device for constant current, and/or is involved in at least one winding, whereas characteristic for such device is, that if electrical current passes through at least one lighting element (16, 42), the device transmits light energy and the light is on.

3. A device according to claims 1 and 2 is **characterized in that**, the thermal effect and heat pumping (2) on at least one thermoelectric element (1), layer, and/or belt, and/or foil is realized by conduction, and/or by convection, and/or by radiation, and/or is provided with at least one cooler (18), and/or with at least one heat conductor (7), and/or with at least one thermosiphon (9, 23), and/or is provided with at least one passive thermal circulation circuit (26), and/or is provided with at least one active circulation circuit (26) with a drive (27), and/or where a drive is at least one pump (27), and/or the heat pumping is realized with motor and propeller for air flow.

4. A device according to claims 1 to 3 is **characterized in that**, into the device for the production of light can be connected at least one socket, and/or clamps for connection of cable, and/or wires for supply of electricity from another power source for an accumulator (22, 39) and for at least one lighting element (16, 42), and/or for other electrical parts of the device.

5. A device according to claims 1 to 3 is **characterized in that**, the device for the production of light is constructed for placing onto at least one source of thermal energy (5), and/or into the zone of activity of thermal energy from such source of thermal energy (5), especially through contact connection of at least one side of thermoelectric element (1), layer, and/or belt, and/or foil of the source(s) (5), and/or at least one thermoelectric element, layer, and/or belt, and/or foil (1) is exposed to thermal radiation and/or to covection from the source(s) (5).

6. A device according to claims 1 to 5 is **characterized in that**, the device for the production of light (6, 8) is placed on at least one source of thermal energy (5), and/or into the zone of thermal activity of such source of thermal energy (5), and the device for the production of light (6, 8) is constructed as portable.

7. A device according to claim 6 is **characterized in that**, the device for the production of light (6, 8) is constructed for placing onto at least one source of thermal energy (5), and/or into the zone of thermal activity from such source (5), the device is placed especially through superimposing on the source and/or sources, and/or through standing, and/or through a thread connection, and/or a magnetic connection, and/or a mechanical connection, and/or a clasp connection, and/or is located on the source and/or sources (5) through hanging, and/or is placed by inserting into at least one shaped groove, and/or is placed in another suitable manner so, that it can be easily and without any particular breach and damage taken away and carried.

8. A device according to claims 1 to 5 is **characterized in that**, the device for the production of light (6, 8) is fixated onto at least one source of thermal energy (5), and/or into the zone of thermal activity of such source(s) (5) through gluing, and/or through soldering, and/or through welding.

9. A device according to claims 1 to 5 or 8 is **characterized in that**, in the location on at least one source of thermal energy (5), and/or in the zone of thermal activity of such source(s) (5) is placed as permanent.

10. A Device for the production of electricity or a power generator is **characterized in that**, it contains as a whole (28) at least one source of thermal energy (5), and/or at least one thermoelectric element, and/or layer, and/or belt, and/or foil (1), connecting and interconnecting insulated metal and/or optical cables (32), and/or control device (33) for changing of polarity, and/or at least one photovoltaic generator (34), and/or at least one wind power generator (35), and/or at least one water generator (36), and/or at least one co-generation electricity generator, and/or at least one generator with fuel cells, and/or at least one hydrogen generator, and/or other environmentally friendly electricity generator (37), and includes voltage controller (38), at least one accumulator (39) for storing of produced electricity with protection against deep discharge (40), can also include monitor of functioning (41), thermometer (44) with sensors (45 a, b, c, ..), circuit of lighting or lights (42), and/or electrical devices (43) on direct current, and/or electrical devices (46) on alternating current, and/or connection to the electricity distribution network (47), whereas various electrical devices, which can be connected and powered by electricity from energy generator (28) are especially televisions, television signal receivers, radios, audio and video players, cameras, monitoring and warning devices, lights and lighting, lamps, microwave ovens, computers, monitors, printers, mobile phones, telephones, shredders, fax machines, mixers, food processors, electric kettles, electric stoves and ovens, induction hobs, batteries, battery chargers, toasters, grills, fans, irons, vacuum cleaners, electric hand-held or stationary tools and machines, drive for tools, dishwashers, washing machines, dryers, fans, sewing and knitting machines, mowers, pressure washing equipment, welding machines, refrigerators, freezers, copiers, portable and stationary air conditioning and heaters, heating and cooling devices, heaters, scales, mesuring devices, compressors, motors, water and fluids pumps, various electric heating pads and cables, equipment for temperature and air quality, and/or various electrical devices, simply home and office and industrial electrical devices and systems.
